# EUROPEAN PATENT APPLICATION

(11) **EP 4 534 740 A1**
(43) Date of publication of application: **09.04.2025**
(21) Application number: 23811741.0
(22) Date of filing: 18.05.2023
(51) Int. Cl.: C30B 29/38, C30B 29/06, H01L 21/02, H01L 21/205

(54) **SUBSTRATE FOR ELECTRONIC DEVICE, AND MANUFACTURING METHOD THEREFOR**

(30) Priority: 27.05.2022 JP 2022087075; 12.09.2022 JP 2022144862
(71) Applicant: Shin-Etsu Handotai Co., Ltd., Tokyo 100-0004 (JP)
(72) Inventor: HAGIMOTO, Kazunori, Annaka-shi, Gunma 379-0196 (JP)
(74) Representative: Röthinger, Rainer
(86) International application number: PCT/JP2023/018662
(87) International publication number: WO 2023/228868

(57) **Abstract**

The present invention is a substrate for an electronic device, including a nitride semiconductor film formed on a bonded substrate comprising a silicon single crystal, in which the bonded substrate is a substrate including a first silicon single-crystal substrate having a crystal plane orientation of {111} and a second silicon single-crystal substrate having a crystal plane orientation of {111}, being bonded via an oxide film, and the oxide film has a thickness of 2 nm or more and 470 nm or less. This provides the substrate for an electronic device in which a nitride semiconductor is formed on the silicon single crystal, and the substrate for an electronic device having a higher breaking strength.

## Description

### TECHNICAL FIELD

The present invention relates to a substrate for an electronic device and a method for producing the same, in particular, a substrate for an electronic device where a nitride semiconductor is formed on a silicon substrate and a method for producing the same.

### BACKGROUND ART

Nitride semiconductors, including GaN and AlN, can be used for fabricating high electron mobility transistors (HEMT) and electronic devices with a high breakdown voltage that use two-dimensional electron gas.

It is difficult to produce a nitride semiconductor wafer having a nitride semiconductor grown on a substrate, and a sapphire substrate or a SiC substrate is conventionally used as a growth substrate. However, in order to suppress costs for achieving a larger diameter substrate (diameter enlargement) and costs for a substrate, epitaxial growth of a nitride semiconductor by vapor phase growth on a silicon single-crystal substrate has been employed. When an epitaxially grown film of the nitride semiconductor is produced by vapor phase growth on a silicon single-crystal substrate, a substrate with a larger diameter can be used compared to a sapphire substrate or a SiC substrate; thus, the productivity of devices is high, and there are advantages regarding ease of processing. However, due to stress caused by a difference in lattice constant or a difference in thermal expansion coefficient, an increase in warps, slips, cracks, and the like easily occurs at the vapor phase growth on the nitride semiconductor on the silicon single-crystal substrate. Therefore, stress reduction is carried out through growth conditions and a relief layer.

For example, in the epitaxial growth on the silicon single-crystal substrates, an AlN buffer layer is stacked on a bare Si substrate and a GaN-HEMT structure epitaxial layer is stacked thereon to produce epitaxial substrates for power devices or RF devices. In particular, in order to make the epitaxial substrates for the power devices to have high breakdown voltage, it is necessary to produce GaN on Si (GaN on a silicon single-crystal) in which an epitaxial layer of GaN has increased thickness. To increase the thickness of the epitaxial layer, the silicon single-crystal substrate, being the growth substrate, may be thickened and epitaxially grown. In addition, as a method to thicken the silicon single-crystal substrate, bonding of two silicon single-crystal substrates has been conducted. Patent Document 1 discloses the thickness of a bonded substrate of 2 mm or more. Moreover, Patent Document 2 discloses a combination of two substrates to be bonded, including a bond wafer having a plane orientation of {111}, and a base wafer having a plane orientation of {100} and a resistivity of 0.1 Ωcm or less.

### CITATION LIST

### PATENT LITERATURE

Patent Document 1: JP 2021-014376 A
Patent Document 2: JP 2021-027186 A

### SUMMARY OF INVENTION

### TECHNICAL PROBLEM

As described above, it is known that a bonded substrate (bonded substrate), in which two substrates are bonded, as disclosed in Patent Documents 1 and **2,** is used as a growth substrate. However, a substrate for an electronic device having even higher breaking strength has been desired.

The present invention has been made to solve the above-described problem. An object of the present invention is to provide a substrate for an electronic device, including a nitride semiconductor formed on a silicon single-crystal, which is the substrate for an electronic device with higher breaking strength, and a method for producing such a substrate.

### SOLUTION TO PROBLEM

To solve the above problem, the present invention provides a substrate for an electronic device, comprising a nitride semiconductor film formed on a bonded substrate comprising a silicon single crystal, wherein
the bonded substrate is a substrate comprising a first silicon single-crystal substrate having a crystal plane orientation of {111} and a second silicon single-crystal substrate having a crystal plane orientation of {111}, being bonded via an oxide film, and
the oxide film has a thickness of 2 nm or more and 470 nm or less.

In this way, in the substrate for an electronic device including the nitride semiconductor film formed on the bonded substrate including the silicon single crystal, when the bonded substrate is a substrate bonded via the oxide film and the film thickness of the oxide film is thin such as 2 nm or more and 470 nm or less, it is possible to make the substrate for an electronic device having higher breaking strength.

Moreover, the present invention provides a substrate for an electronic device, comprising a nitride semiconductor film formed on a bonded substrate comprising a silicon single crystal, wherein
the bonded substrate is a substrate comprising a first silicon single-crystal substrate having a crystal plane orientation of {111} and a second silicon single-crystal substrate, being bonded via an oxide film, and
the oxide film has a thickness of 2 nm or more and 470 nm or less.

Even in such an aspect, in the substrate for an electronic device including the nitride semiconductor film formed on the bonded substrate including the silicon single crystal, when the bonded substrate is a substrate bonded via the oxide film and the film thickness of the oxide film is thin such as 2 nm or more and 470 nm or less, it is possible to make the substrate for an electronic device having higher breaking strength.

In this case, the second silicon single-crystal substrate can have a crystal plane orientation of {100}.

Even when the first silicon single-crystal substrate and the second silicon single-crystal substrate are made to have a combination of such crystal plane orientations, the substrate for an electronic device having high breaking strength can be made.

Moreover, in the inventive substrate for an electronic device, the oxide film can have a thickness of 2 nm or more and 190 nm or less.

The inventive substrate for an electronic device can be the substrate for an electronic device having high breaking strength by making the oxide film thickness in such a range.

In this case, the bonded substrate is preferably a substrate being bonded where a notch of the first silicon single-crystal substrate and a notch of the second silicon single-crystal substrate are rotationally shifted between 15° and 165°.

Such a substrate can be the substrate for an electronic device having higher breaking strength.

Moreover, the bonded substrate can have a diameter of 300 mm or more.

In this way, the substrate having a high breaking strength of the present invention is particularly effective for the substrate for an electronic device having a large diameter such as a diameter of 300 mm or more.

Moreover, the present invention provides a method for producing a substrate for an electronic device by forming a nitride semiconductor film on a bonded substrate comprising a silicon single crystal, the method comprising the steps of:
providing a first silicon single-crystal substrate having a crystal plane orientation of {111}, and a second silicon single-crystal substrate having a crystal plane orientation of {111};
forming an oxide film on a surface of at least one of the first silicon single-crystal substrate and the second silicon single-crystal substrate;
producing the bonded substrate by laminating the first silicon single-crystal substrate and the second silicon single-crystal substrate via the oxide film and then heat treating to bond the first silicon single-crystal substrate and the second silicon single-crystal substrate; and
epitaxially growing the nitride semiconductor film on the surface of the first silicon single-crystal substrate of the bonded substrate, wherein
the oxide film to be formed in the step of forming the oxide film is formed to have a thickness in which a thickness of an oxide film that is sandwiched between the first silicon single-crystal substrate and the second silicon single-crystal substrate is 2 nm or more and 470 nm or less.

According to such an inventive method for producing a substrate for an electronic device, the bonded substrate is a substrate bonded via the oxide film, and the film thickness of the oxide film can be thin, such as 2 nm or more and 470 nm or less, thereby enabling the production of the substrate for an electronic device having higher breaking strength.

Moreover, the present invention provides a method for producing a substrate for an electronic device by forming a nitride semiconductor film on a bonded substrate comprising a silicon single crystal, the method comprising the steps of:
providing a first silicon single-crystal substrate having a crystal plane orientation of {111}, and a second silicon single-crystal substrate;
forming an oxide film on a surface of at least one of the first silicon single-crystal substrate and the second silicon single-crystal substrate;
producing the bonded substrate by laminating the first silicon single-crystal substrate and the second silicon single-crystal substrate via the oxide film and then heat treating to bond the first silicon single-crystal substrate and the second silicon single-crystal substrate; and
epitaxially growing the nitride semiconductor film on the surface of the first silicon single-crystal substrate of the bonded substrate, wherein
the oxide film to be formed in the step of forming the oxide film is formed to have a thickness in which a thickness of an oxide film that is sandwiched between the first silicon single-crystal substrate and the second silicon single-crystal substrate is 2 nm or more and 470 nm or less.

Even in such an aspect, in the inventive method for producing a substrate for an electronic device, the bonded substrate is a substrate bonded via the oxide film, and the film thickness of the oxide film can be thin, such as 2 nm or more and 470 nm or less, thereby enabling the production of the substrate for an electronic device having higher breaking strength.

In this case, the second silicon single-crystal substrate can have a crystal plane orientation of {100}.

Even when the first silicon single-crystal substrate and the second silicon single-crystal substrate are made to have a combination of such crystal plane orientations, the substrate for an electronic device having high breaking strength can be produced.

Moreover, in the inventive method for producing a substrate for an electronic device, the oxide film to be formed in the step of forming the oxide film can be formed to have a thickness in which a thickness of an oxide film that is sandwiched between the first silicon single-crystal substrate and the second silicon single-crystal substrate is 2 nm or more and 190 nm or less.

In the present invention, the substrate for an electronic device having high breaking strength can be produced by making the oxide film thickness in such a range.

In this case, it is preferred that the first silicon single-crystal substrate and the second silicon single-crystal substrate are bonded where a notch of the first silicon single-crystal substrate and a notch of the second silicon single-crystal substrate are rotationally shifted between 15° and 165°.

According to such a production method, the substrate for an electronic device having higher breaking strength can be produced.

Moreover, the first silicon single-crystal substrate and the second silicon single-crystal substrate to be provided can have diameters of 300 mm or more.

A substrate having high breaking strength such as the substrate for an electronic device produced by the inventive production method is particularly effective in producing the substrate for an electronic device having a large diameter such as a diameter of 300 mm or more.

### ADVANTAGEOUS EFFECTS OF INVENTION

The substrate for an electronic device as in the present invention, is the substrate, which is the bonded substrate bonded via the oxide film, and has a thickness of the oxide film which is thin such as 2 nm or more and 470 nm or less; thus, the substrate for an electronic device having higher breaking strength can be provided. Moreover, the inventive method for producing a substrate for an electronic device can produce such a substrate for an electronic device. Therefore, the quality of the substrate for an electronic device including the nitride semiconductor film formed thereon can be improved and productivity thereof can be increased.

### BRIEF DESCRIPTION OF DRAWINGS

FIG. 1 is a schematic cross-sectional view illustrating an example of a substrate for an electronic device according to the present invention.
FIG. 2 is a conceptual diagram describing a positional relation between notches of a first silicon single-crystal substrate and a second silicon single-crystal substrate viewed from a main surface side of a bonded substrate of a substrate for an electronic device according to the present invention.
FIG. 3 is a flowchart illustrating a schematic of an example of a method for producing a substrate for an electronic device according to the present invention.
FIG. 4 is a schematic view illustrating a state of a breaking load test. (a) View from above in a vertical direction. (b) View from side.
FIG. 5 is a graph showing results of Examples 1-1 to 1-9 and Comparative Examples 1-1 and 1-2, and Examples 3-1 to 3-8 and Comparative Examples 3-1 and 3-2.
FIG. 6 is a graph showing results of Examples 2-1 to 2-8, and Examples 4-1 to 4-8.

### DESCRIPTION OF EMBODIMENTS

Hereinafter, the present invention is described in detail with referring to the drawings. However, the present invention is not limited thereto.

### [Substrate for Electronic Device]

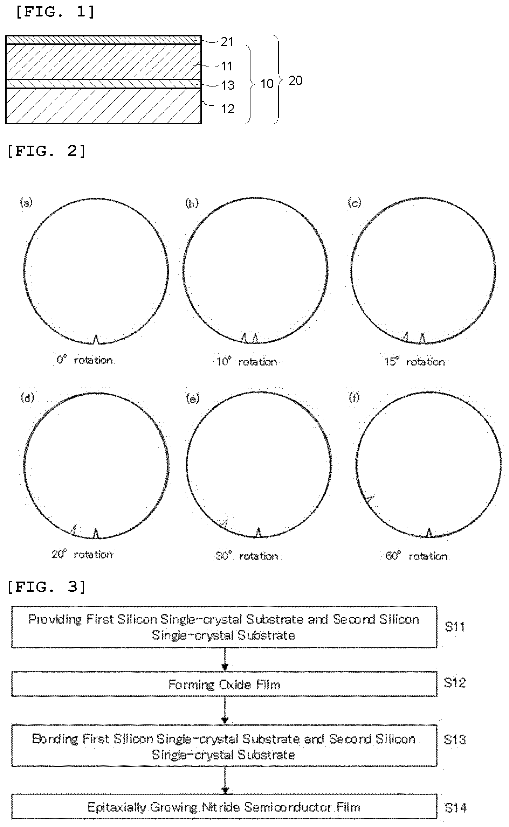

As shown in FIG. 1, the inventive substrate 20 for an electronic device has a nitride semiconductor film 21 formed on a bonded substrate 10 including silicon single crystal. In the description of the present invention, the bonded substrate 10 including silicon single crystal is also referred to simply as "bonded substrate." In this case, the bonded substrate 10 is the substrate in which a first silicon single-crystal substrate 11 having a crystal plane orientation of {111} and a second silicon single-crystal substrate 12 having a crystal plane orientation of {111} are bonded via an oxide film 13. As shown in FIG. 1, the nitride semiconductor film 21 is formed on the first silicon single-crystal substrate 11. The inventive substrate 20 for an electronic device is characterized in that the oxide film 13 has a thickness of 2 nm or more and 470 nm or less.

Moreover, a bonded substrate 10 may be a substrate in which a first silicon single-crystal substrate 11 having a crystal plane orientation of {111} and a second silicon single-crystal substrate 12 are bonded via an oxide film 13. In this case, as well, as shown in FIG. 1, a nitride semiconductor film 21 is formed on the first silicon single-crystal substrate 11. The inventive substrate 20 for an electronic device is characterized in that the oxide film 13 has a thickness of 2 nm or more and 470 nm or less.

In this case, the crystal plane orientation of the second silicon single-crystal substrate 12 can be {100}.

Other Miller index notations are used in the usual way. That is, {} means a general term for equivalent crystal plane orientations, and () means each direction of the crystal plane orientations. In addition, <> indicates a general term for equivalent crystal axis directions, and [] means each direction of crystal axis directions.

Moreover, each of the crystal plane orientations of the first silicon single-crystal substrate 11 and the second silicon single-crystal substrate 12 may have an off-angle of a few degrees (approximately 5° or less).

As described above, in order to make epitaxial substrates for power devices have high breakdown voltage, it is necessary to produce a substrate for an electronic device formed with a thick nitride semiconductor film on a silicon single-crystal substrate (for example, GaN on Si in which an epitaxial layer of GaN has increased thickness). To increase the thickness of the epitaxial layer, the silicon single-crystal substrate may be thickened, and epitaxial growth may be performed. In addition, as a method to thicken the silicon substrate, it has been performed to bond two silicon single-crystal substrates to make the bonded substrate; however, when such a bonded substrate (bonded substrate) is used, a substrate having higher breaking strength is desired.

In the present invention, in order to make the substrate 20 for an electronic device have higher breaking strength, the thickness of the oxide film 13 is set to be 2 nm or more and 470 nm or less as described above. By using the bonded substrate 10 with the oxide film 13 of this thickness range, which is interposed in the bonded substrate, rather than a case where the oxide film is not formed, the breaking strength of the bonded substrate 10 can be improved. Accordingly, even when the nitride semiconductor film 21 is formed on the bonded substrate 10, the breaking strength can be improved. It is considered that the oxide film 13 can function as a buffer layer when stress is applied, as the film oxide film 13 is interposed in the bonded substrate. The thickness of the oxide film 13 is preferably 2 nm or more and 190 nm or less, due to a magnitude of an effect and an ease of controlling the thickness of the oxide film. Even when the thickness of the oxide film 13 is increased to a thickness exceeding 470 nm, the effect of forming the oxide film 13 decreases gradually, and an oxidation time for forming the oxide film 13 also increases, and thus a benefit is absent.

Moreover, in the present invention, it is preferred that the bonded substrate 10 including silicon single crystal is a substrate being bonded where a notch of the first silicon single-crystal substrate and a notch of the second silicon single-crystal substrate are rotationally shifted between 15° and 165°. By shifting the position of the notches in the bonded substrate 10 in this manner, the breaking strength can be further improved.

Moreover, the bonded substrate can have a diameter of 300 mm or more.

In this way, the inventive substrate having high breaking strength is particularly effective for the substrate for an electronic device having a large diameter such as a diameter of 300 mm or more.

In the inventive substrate 20 for an electronic device, the diameter of the bonded substrate 10 (and the substrate 20 for an electronic device) can also be made to be a large diameter of 300 mm or more because of the high substrate strength, as described above. Conventionally, the substrate having such a large diameter has a case where the substrate strength is insufficient, and the crack, and the like are generated; however, the inventive substrate for an electronic device can be made with high breaking strength, as described above. The upper limit of the diameter of the bonded substrate 10 (and the substrate 20 for an electronic device) is not particularly limited but can be, for example, 450 mm or less.

When the diameter of the bonded substrate 10 (and the substrate 20 for an electronic device) is 300 mm or more, the diameters of the first silicon single-crystal substrate 11 and the second silicon single-crystal substrate 12 are also 300 mm or more. The respective thicknesses of the first silicon single-crystal substrate 11 and the second silicon single-crystal substrate 12 are not particularly limited but can be suitably used in accordance with standards. In particular, when the diameter is 300 mm, the thickness can be 775 µm. Such a silicon single-crystal substrate is used as a general substrate for a device, is inexpensive, and can be used without particular problems. A thickness of 500 µm to 1500 µm can be used for the first silicon single-crystal substrate 11 and the second silicon single-crystal substrate 12, for example. The thicknesses of the first silicon single-crystal substrate 11 and the second silicon single-crystal substrate 12 are not required to be the same, that is, the ratio of the thicknesses of the first silicon single-crystal substrate 11 and the second silicon single-crystal substrate 12 is not limited to 1. Even when the ratio of thicknesses is other than 1, the same effect can be obtained when a total thickness of the bonded substrate 10 is the same.

The thickness of the bonded substrate 10 in which the first silicon single-crystal substrate 11 and the second silicon single-crystal substrate 12 are bonded is not limited to 775 µm × 2. It is known that the strength against breaking load increases with the thickness of the substrate. Hence in a configuration of the present invention, for example, when the bonded substrate 10, being bonded, is made to correspond to one typically distributed substrate having a specification thickness of 775 µm and a diameter of 300 mm, the strength of such a bonded substrate is no match for the strength of the bonded substrate in which the first silicon single-crystal substrate 11 and the second silicon single-crystal substrate 12, both having a thickness of 775 µm (total thickness is approximately 1550 µm) are bonded in a configuration of the present invention; however, the strength thereof is greatly increased compared to one single substrate having the same thickness (775 µm). Naturally, in this case, a thickness ratio of the first silicon single-crystal substrate 11 and the second silicon single-crystal substrate 12 is not limited to 1. As a method for producing such a bonded substrate 10 having a thickness of 775 µm, two thin substrates, the first silicon single-crystal substrate 11 and the second silicon single-crystal substrate 12 may be bonded to make the total thickness of 775 µm or the thickness may be adjusted to 775 µm by bonding two typical specification substrates (775 µm each) and then by grinding them.

A positional relation between the notch of the first silicon single-crystal substrate 11 and the notch of the second silicon single-crystal substrate 12 in the bonded substrate 10 is described referring to FIG. 2. In all of FIGS. 2 (a) to (f), the crystal plane orientations of the first silicon single-crystal substrate 11 and the silicon single-crystal substrate 12 are {111}, and the substrates having the notch positions in <110> direction are shown as examples. FIGS. 2 (a), (b), (c), (d), (e), and (f) show, respectively, no rotation (0° rotation), 10° rotation, 15° rotation, 20° rotation, 30° rotation, and 60° rotation for the notch positions. That is, in each drawing of FIGS. 2 (a) to (f), the notch positions of the first silicon single-crystal substrate 11 are shown facing directly downward for convenience, and the notch positions of the second silicon single-crystal substrate 12 shown by dashed lines are shifted according to angles of each drawing.

In the inventive substrate 20 for an electronic device, in addition to having the bonded substrate 10 bonded via the oxide film 13 as described above, the breaking strength can be further increased by having the notch of the first silicon single-crystal substrate 11 and notch of the second silicon single-crystal substrate 12 rotationally shifted as in FIGS. 2 (b) to (f). The angle of rotational shift is preferably shifted rotationally, in particular, 15° or more as in FIGS. 2 (c) to (f), rather than 10° in FIG. 2 (b). Moreover, it is preferred that the rotational shift of the positions of the notch of the first silicon single-crystal substrate 11 and the notch of the second silicon single-crystal substrate 12 is 15° or more and 165° or less.

The respective directions of the notches of the first silicon single-crystal substrate 11 and the second silicon single-crystal substrate 12 are not particularly limited. The notch positions of the first silicon single-crystal substrate 11 and the second silicon single-crystal substrate 12 are not limited to <110> direction and may be assigned to any direction. The difference in strength due to the angler shift of the notches is caused by a relative position of the notches which has physically weak characteristics to the breaking load, thus even when the notches are in the direction other than the <110> direction, the present invention has the same effect.

Moreover, in the inventive substrate 20 for an electronic device, the nitride semiconductor film 21 is formed on a surface of the first silicon single-crystal substrate 11 having the crystal plane orientation of {111}, resulting in an excellent nitride semiconductor film 21 being formed.

### [Method for Producing Substrate for Electronic Device]

Hereinafter, the inventive method for producing a substrate 20 for an electronic device described above is described referring to FIG. 3.

First, as shown in S11 of FIG. 3, a first silicon single-crystal substrate 11 and a second silicon single-crystal substrate 12 are provided (Step S11). In this case, silicon single-crystal substrates both having a crystal plane orientation of {111} are provided as the first silicon single-crystal substrate 11 and the second silicon single-crystal substrate 12. In this case, the diameters of the provided first silicon single-crystal substrate 11 and the provided second silicon single-crystal substrate 12 can be 300 mm or more.

Meanwhile, as another aspect, in addition to providing a first silicon single-crystal substrate 11 having a crystal plane orientation of {111}, a second silicon single-crystal substrate 12 in which a crystal plane orientation is not {111} can be provided in Step S11. In this case, the crystal plane orientation of the second silicon single-crystal substrate 12 is preferably {100}. With such a combination of the first silicon single-crystal substrate 11 and the second silicon single-crystal substrate 12, the following steps can also be performed in the same way.

Moreover, the first silicon single-crystal substrate 11 and the second silicon single-crystal substrate 12 are bonded to make a bonded substrate 20, which is one slice of silicon single-crystal substrate, so the first silicon single-crystal substrate 11 can be referred to as a bond wafer, and the second silicon single-crystal substrate 12 can be referred to as a base wafer.

The respective thicknesses of the first silicon single-crystal substrate 11 and the second silicon single-crystal substrate 12 are not particularly limited but can be suitably used in accordance with standards. Moreover, the respective resistivity and impurity concentration of the first silicon single-crystal substrate 11 and the second silicon single-crystal substrate 12 can be determined as appropriate.

Next, as shown in S12 of FIG. 3, an oxide film is formed on the surface of at least one of the first silicon single-crystal substrate 11 and the second silicon single-crystal substrate 12 (Step S12). The oxide film formed here is a film to be an oxide film 13, as shown in FIG. 1 after bonding of both silicon single-crystal substrates. The forming method of the oxide film is not particularly limited, but, for example, the oxide film (thermal oxide film) can be formed on the surface of the substrate by oxidation heat treatment. The oxide film is formed in a thickness such that the thickness of the oxide film 13 sandwiched between the first silicon single-crystal substrate 11 and the second silicon single-crystal substrate 12 is 2 nm or more and 470 nm or less, after the first silicon single-crystal substrate 11 and the second silicon single-crystal substrate 12 are bonded in Step S13 described later. The oxide film may be formed on each of two silicon single-crystal substrates, or the oxide film may be formed on any one of silicon single-crystal substrates. Moreover, the oxide film formed here may be formed as a native oxide film as long as the film has a thickness of 2 nm or more at bonding.

Next, as shown in S13 of FIG. 3, the first silicon single-crystal substrate 11 and the second silicon single-crystal substrate 12 are bonded (Step S13). At this time, bonding is performed by laminating the first silicon single-crystal substrate 11 and the second silicon single-crystal substrate 12 via the oxide film formed in Step S12 and then heat treating. Thereby, the first silicon single-crystal substrate 11 and the second silicon single-crystal substrate 12 are firmly bonded to produce a bonded substrate 10 (see FIG. 1).

As described above, by forming the oxide film, in Step S12 of forming the oxide film, in a thickness such that the thickness of the oxide film 13 sandwiched between the first silicon single-crystal substrate 11 and the second silicon single-crystal substrate 12 is 2 nm or more and 470 nm or less, naturally, the oxide film 13 can have a thickness of 2 nm or more and 470 nm or less after bonding of both substrates in Step S13. The oxide film formed in this Step S12 is preferably formed in a thickness such that the thickness of the oxide film 13 sandwiched between the first silicon single-crystal substrate 11 and the second silicon single-crystal substrate 12 is 2 nm or more and 190 nm or less.

Conditions (atmosphere, temperature, time, and the like) for heat treatment (bonding heat treatment) are not particularly limited as long as the first silicon single-crystal substrate 11 and the second silicon single-crystal substrate 12 can be bonded. The temperature of this bonding heat treatment can be, for example, at 400°C or higher and 1200°C or lower and the bonding heat treatment can be performed in a nitrogen atmosphere for 1 to 12 hours.

In addition, in Step S13 of bonding both substrates, it is preferable that the bonding is performed in a state where the notch of the first silicon single-crystal substrate 11 and the notch of the second silicon single-crystal substrate 12 are rotationally shifted between 15° and 165° (see FIG. 2).

After this bonding heat treatment, it is preferred to clean a surface of the bonded substrate 10 before the epitaxial growth of a nitride semiconductor film described later. In particular, it is preferred to remove the oxide film generated on the surface of the bonded substrate 10 (in particular, the surface of the first silicon single-crystal substrate 11) by hydrofluoric acid spin cleaning, etc.

In this way, after the bonding of the first silicon single-crystal substrate 11 and the second silicon single-crystal substrate 12 to produce the bonded substrate 10; as shown in S14 in FIG. 3, the nitride semiconductor film 21 (see FIG. 1) is epitaxially grown on the surface of the first silicon single-crystal substrate 11 of the bonded substrate 10 (Step S14). Note that regarding the first silicon single-crystal substrate 11, double-side polishing may be performed before this bonding, or even if not double-side polished before bonding, the main surface to be grown can be single-sided polished after bonding and before epitaxial growth. Naturally, regarding the second silicon single-crystal substrate 12, the double-side polishing may also be performed.

As the nitride semiconductor film 21, an AlN layer, a GaN layer, an AlGaN layer and the like can be formed. This nitride semiconductor film 21 can be formed by a common method. Moreover, an intermediate layer (buffer layer) may be formed as appropriate. In this way, the substrate 20 for an electronic device can be produced, as shown in FIG. 1.

### EXAMPLE

Hereinafter, the present invention will be more specifically described showing Examples and Comparative Examples. However, the present invention is not limited to Example described below.

### (Examples 1-1 to 1-9, Comparative Example 1-1)

In accordance with an inventive method for producing a substrate for an electronic device shown in FIG. 3, a substrate 20 for an electronic device shown in FIG. 1 was produced.

First, as a first silicon single-crystal substrate 11, a double-side polished silicon single-crystal substrate having a diameter of 300 mm, a thickness of 775 µm, a crystal plane orientation of {111}, p-type, and resistivity of 5000 Ωcm with a notch formed in <110> direction was provided; and as a second silicon single-crystal substrate 12, a double-side polished silicon single-crystal substrate having a diameter of 300 mm, a thickness of 775 µm, a crystal plane orientation of {111}, p-type, and resistivity of 5000 Ωcm with a notch formed in <110> direction was provided (Step S11). An interstitial oxygen concentration Oi was 16 ppm (JEIDA standards) for both the first silicon single-crystal substrate 11 and the second silicon single-crystal substrate 12.

Surface oxide films were formed on these two provided silicon single-crystal substrates (Step S12). The oxide film was formed to have a thickness of 2 nm (Example 1-1), 23 nm (Example 1-2), 80 nm (Example 1-3), 150 nm (Example 1-4), 190 nm (Example 1-5), 220 nm (Example 1-6), 280 nm (Example 1-7), 350 nm (Example 1-8), 470 nm (Example 1-9), and 600 nm (Comparative Example 1-1) when the two silicon single-crystal substrates were bonded each other. The specific formation methods were as follows. First, a native oxide film was formed in Example 1-1. In addition, an oxidation heat treatment in Examples 1-2 to 1-9, and Comparative Example 1-1 were performed by a pyrogenic oxidation method. The conditions for the pyrogenic oxidation method were at 900°C for 15 minutes (Example 1-2), at 900°C for 60 minutes (Example 1-3), at 900°C for 142 minutes (Example 1-4), at 900°C for 199 minutes (Example 1-5), at 900°C for 214 minutes (Example 1-6), at 900°C for 256 minutes (Example 1-7), at 900°C for 301 minutes (Example 1-8), at 1000°C for 213 minutes (Example1-9), and at 1000°C for 275 minutes (Comparative Example 1-1), respectively.

Next, two silicon single-crystal substrates were laminated by aligning the notch positions, and then a bonding heat treatment was performed at 500°C in a nitrogen atmosphere to produce a bonded substrate 10 (Step S13). Subsequently, hydrofluoric acid spin cleaning was performed on the bonded substrate 10 to remove the oxide film on the surface of the bonded substrate 10.

Next, an AlN layer of 150 nm, an AlGaN layer of 160 nm, a superlattice structure with 25 alternating pairs of GaN layers and AlN layers laminated, a GaN layer of 1000 nm, an AlGaN layer of 20 nm, and a GaN layer of 3 nm were epitaxially grown to a total thickness of 1.8 µm on the surface of the first silicon single-crystal substrate 11 of the bonded substrate 10 as a nitride semiconductor film 21 (Step S14).

As a result, in Example 1-1 to Example 1-9, the nitride semiconductor films 21 were successfully formed without generating cracks, etc. In this way, the substrates 20 for an electronic device were produced.

Additionally, the bonded substrates, before forming the nitride semiconductor film, were produced under the same conditions as in each of Example 1-1 to Example 1-9 and Comparative Example 1-1, and the strength of each bonded substrate was measured.

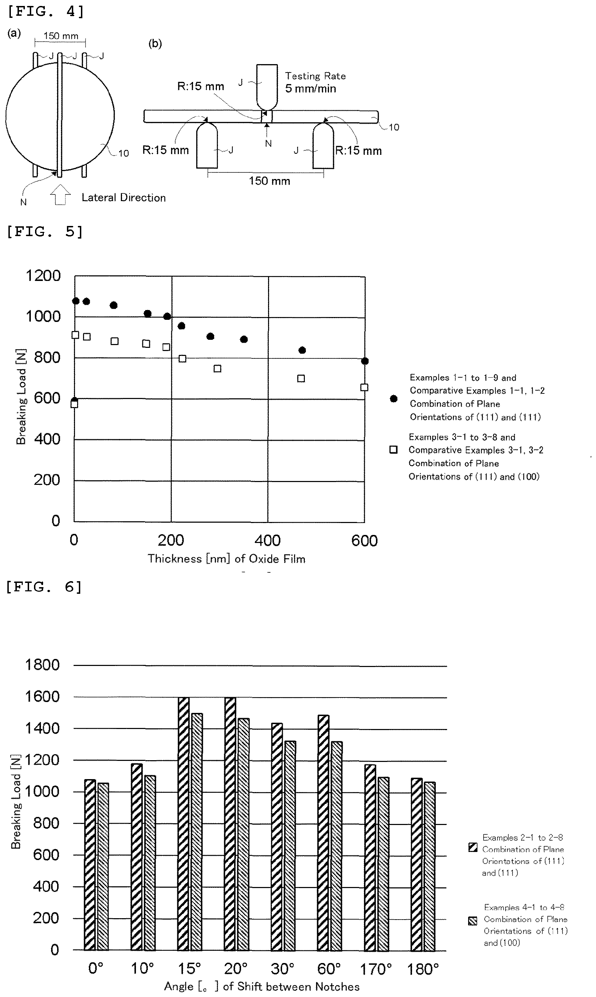

In this strength measurement of the bonded substrates, as shown in FIG. 4, breaking load was investigated using a Universal Testing System manufactured by INSTRON Corporation. FIG. 4 (a) is a top view from the vertical direction, and FIG. 4 (b) is a side view.

As shown in FIGS. 4 (a) and (b), three fulcrum jigs J (curvature radius R of crimping points is 15 mm) were arranged above and below the bonded substrate. In the bonded substrate, the notch position was weak in terms of strength, thus, the notch position N was arranged to be just below the central fulcrum jig J (see FIGS. 4 (a) and (b)).

### (Comparative Example 1-2)

Although a process up to the production of a bonded substrate was performed in the same way as in Example 1-1, the following points were changed. After providing a first silicon single-crystal substrate 11 and a second silicon single-crystal substrate 12, an oxide film formation in Step S12 was not performed on both substrates. Moreover, native oxide films on bonding surfaces of both substrates were removed by subjecting them to HF spin cleaning. Subsequently, both substrates were bonded in a state where the native oxide films were removed. The investigation of breaking load to this substrate (bonded substrate without interposing oxide film) was performed in the same way as above.

### (Comparative Example 1-3)

One first silicon single-crystal substrate 11, being the same substrate as in Example 1-1, was provided. The investigation of breaking load to this single substrate was performed in the same way as above.

Results of breaking load (strength) above are summarized in Table 1. In addition, FIG. 5 shows the results plotted for Examples 1-1 to 1-9, and Comparative Examples 1-1 and 1-2 (FIG. 5 also shows the results for Examples 3-1 to 3-8, and Comparative Examples 3-1 and 3-2, described later).

### [Table 1]

As shown here, the strengths of the bonded substrates 10 in Example 1-1 to Example 1-9 were higher than those in Comparative Examples 1-1 to 1-3. Moreover, the strength in the case where two silicon single-crystal substrates were bonded without the oxide film in Comparative Example 1-2 was only about twice the strength of unbonded single silicon single-crystal substrate in Comparative Example 1-3. In contrast, in Example 1-1 to Example 1-9 in which the bonded substrates 10 being bonded via the oxide film 13

| | Comparative Example 1-2 | Example 1-1 | Example 1-2 | Example 1-3 | Example 1-4 | Example 1-5 | Example 1-6 | Example 1-7 | Example 1-8 | Example 1-9 | Comparative Example 1-1 | Comparative Example 1-3 |
|---|---|---|---|---|---|---|---|---|---|---|---|---|
| Thickness (nm) of Oxide Film | 0 (Not Formed) | 2 | 23 | 80 | 150 | 190 | 220 | 280 | 350 | 470 | 600 | Absent (Single substrate) |
| Strength (N) | 590 | 1080 | 1077 | 1058 | 1019 | 1005 | 958 | 908 | 893 | 842 | 790 | 305 |

were used, it was indicated that the strength was significantly improved greatly exceeding the strength of the unbonded single silicon single-crystal substrate by more than double. Moreover, in Comparative Example 1-1 (600nm), in which the oxide film had a thickness exceeding 470 nm, the effect of the oxide film was decreased, and sufficient strength was unable to be obtained, in addition, it took time for forming the oxide film.

### (Example 2-1)

A substrate 20 for an electronic device was produced by performing Steps S11 to S14 in the same way as in Example 1-1 (a native oxide film was formed, and an oxide film 13 after bonding had a thickness of 2 nm).

### (Examples 2-2 to 2-8)

Substrates 20 for an electronic device were produced in the same way as in Example 2-1, provided that notch positions of a first silicon single-crystal substrate 11 and a second silicon single-crystal substrate 12 were shifted by rotation. Amounts of rotational shift were set to 10° (Example 2-2), 15° (Example 2-3), 20° (Example 2-4), 30° (Example 2-5), 60° (Example 2-6), 170° (Example 2-7), and 180° (Example 2-8).

In Example 2-1 to Example 2-8, nitride semiconductor films 21 were successfully formed without generating cracks, etc.

Moreover, bonded substrates 10 before forming a nitride semiconductor film were produced under the same conditions as in each of Example 2-1 to Example 2-8, and strength (breaking load) of each bonded substrate was measured. The strength measurements of each of the bonded substrates 10 were performed in the same way in Example 1-1 to Example 1-9, and Comparative Examples 1-1 to 1-3. Results of above breaking load (strength) are summarized in Table 2 and FIG. 6 (Examples 4-1 to 4-8 described later are also shown in FIG. 6).

**[Table 2]**

| | Example 2-1 | Example 2-2 | Example 2-3 | Example 2-4 | Example 2-5 | Example 2-6 | Example 2-7 | Example 2-8 |
|---|---|---|---|---|---|---|---|---|
| Notch Shift (°) | 0 | 10 | 15 | 20 | 30 | 60 | 170 | 180 |
| Strength(N) | 1080 | 1181 | 1602 | 1597 | 1440 | 1492 | 1181 | 1095 |

All of the bonded substrates 10 in Example 2-1 to Example 2-8 had improved strength than those in Comparative Examples 1-1 to 1-3.

Among Examples 2-1 to 2-8, the bonded substrates 10 in Examples 2-3 to 2-6 had particularly high strength, with even higher strength than Examples 2-1 and 2-2, where a rotational shift between notches of both substrates was less than 15°.

Additionally, the rotational shifts of the notches of both substrates were 170° and 180° in Examples 2-7 and 2-8, respectively, and in these cases, the notches were positioned on the opposite side of a substrate in contrast with respective cases of 10° and 0° (i.e., Examples 2-2 and 2-1). When comparing the strength in Example 2-1 (0°) and the strength in Example 2-8 (180°), the values thereof were close, and when comparing the strength in Example 2-2 (10°) and the strength in Example 2-7 (170°), the values were close. Consequently, when the rotational shifts of the notches of both substrates are 170° and 180°, this is considered equivalent to when the rotational shifts of the notches of both substrates are 10° and 0°, respectively. Accordingly, for example, when the rotational shifts of the notches of both substrates are 15° and 165°, this is considered equivalent. From the above, it is considered preferable to set the rotational shift of the notches of both substrates between 15° and 165°.

### (Examples 3-1 to 3-8, Comparative Example 3-1)

A substrate 20 for an electronic device shown in FIG. 1 was produced by the inventive method for producing a substrate for an electronic device shown in FIG. 3. Here, differently from Example 1-1, etc., a substrate having a crystal plane orientation of {100} and a notch formed in <100> direction was used as a second silicon single-crystal substrate 12.

First, as a first silicon single-crystal substrate 11, a double-side polished silicon single-crystal substrate having a diameter of 300 mm, a thickness of 775 µm, a crystal plane orientation of {111}, p-type, and resistivity of 5000 Ωcm with a notch formed in <110> direction was provided; and as the second silicon single-crystal substrate 12, a double-side polished silicon single-crystal substrate having a diameter of 300 mm, a thickness of 775 µm, a crystal plane orientation of {100}, p-type, and resistivity of 5000 Ωcm with a notch formed in <100> direction was provided (Step S11). An interstitial oxygen concentration Oi was 16 ppm (JEIDA standards) for both the first silicon single-crystal substrate 11 and the second silicon single-crystal substrate 12.

Surface oxide films were formed on these two provided silicon single-crystal substrates (Step S12). The oxide film was formed to have a thickness of 2 nm (Example 3-1), 25 nm (Example 3-2), 83 nm (Example 3-3), 148 nm (Example 3-4), 189 nm (Example 3-5), 223 nm (Example 3-6), 295 nm (Example 3-7), 468 nm (Example 3-8), and 599 nm (Comparative Example 3-1) when the two silicon single-crystal substrates were bonded each other. The specific formation methods were as follows. First, a native oxide film was formed in Example 3-1. In addition, an oxidation heat treatment in Examples 3-2 to 3-8 was performed by a pyrogenic oxidation method. The conditions for the pyrogenic oxidation method were at 900°C for 15 minutes (Example 3-2), at 900°C for 60 minutes (Example 3-3), at 900°C for 142 minutes (Example 3-4), at 900°C for 199 minutes (Example 3-5), at 900°C for 214 minutes (Example 3-6), at 900°C for 256 minutes (Example 3-7), at 1000°C for 213 minutes (Example 3-8), and at 1000°C for 275 minutes (Comparative Example 3-1), respectively.

Next, two silicon single-crystal substrates were laminated by aligning the notch positions, and then a bonding heat treatment was performed at 500°C in a nitrogen atmosphere to produce a bonded substrate 10 (Step S13). Subsequently, hydrofluoric acid spin cleaning was performed on the bonded substrate 10 to remove the oxide film on the surface of the bonded substrate 10.

Next, an AlN layer of 150 nm, an AlGaN layer of 160 nm, a superlattice structure with 25 alternating pairs of GaN layers and AlN layers laminated, a GaN layer of 1000 nm, an AlGaN layer of 20 nm, and a GaN layer of 3 nm were epitaxially grown to a total thickness of 1.8 µm on the surface of the first silicon single-crystal substrate 11 of the bonded substrate 10 as a nitride semiconductor film 21 (Step S14).

As a result, in Example 3-1 to Example 3-8, the nitride semiconductor films 21 were successfully formed without generating cracks, etc. In this way, the substrates 20 for an electronic device were produced.

Additionally, the bonded substrates, before forming the nitride semiconductor film, were produced under the same conditions as in each of Example 3-1 to Example 3-8 and Comparative Example 3-1, and the strengths were measured in the same way described above.

### (Comparative Example 3-2)

Although a process up to the production of a bonded substrate was performed in the same way as in Example 3-1, the following points were changed. After providing the first silicon single-crystal substrate 11 and the second silicon single-crystal substrate 12, the oxide film formation in Step S12 was not performed on both substrates. Moreover, native oxide films on bonding surfaces of both substrates were removed by subjecting them to HF spin cleaning. Subsequently, both substrates were bonded in a state where the native oxide films were removed. The investigation of breaking load to this substrate (bonded substrate without interposing oxide film) was performed in the same way as above.

Results of breaking load (strength) above are summarized in Table 3. In addition, FIG. 5 shows the results plotted for Examples 3-1 to 3-8, and Comparative Examples 3-1 and 3-2.

**[Table 3]**

| | Comparative Example 3-2 | Example 3-1 | Example 3-2 | Example 3-3 | Example 3-4 | Example 3-5 | Example 3-6 | Example 3-7 | Example 3-8 | Comparative Example 3-1 |
|---|---|---|---|---|---|---|---|---|---|---|
| Thickness (nm) of Oxide Film | 0 (Not Formed) | 2 | 25 | 83 | 148 | 189 | 223 | 295 | 468 | 599 |
| Strength (N) | 571 | 912 | 902 | 881 | 871 | 854 | 798 | 750 | 702 | 661 |

As shown here, the strengths of the bonded substrates 10 in Example 3-1 to Example 3-8 were higher than those in Comparative Examples 3-1 and 3-2. Moreover, the strength in the case where two silicon single-crystal substrates were bonded without the oxide film in Comparative Example 3-2 was only about twice the strength of an unbonded single silicon single-crystal substrate in Comparative Example 1-3. In contrast, in Example 3-1 to Example 3-8 in which the bonded substrates 10 being bonded via the oxide film 13 were used, it was indicated that the strength was significantly improved greatly exceeding the strength of the unbonded single silicon single-crystal substrate by more than double.

### (Example 4-1)

A substrate 20 for an electronic device was produced by performing Steps S11 to S14 in the same way as in Example 3-1 (a native oxide film was formed, and an oxide film 13 after bonding had a thickness of 2 nm).

### (Examples 4-2 to 4-8)

Substrates 20 for an electronic device were produced in the same way as in Example 4-1, provided that notch positions of a first silicon single-crystal substrate 11 and a second silicon single-crystal substrate 12 were shifted by rotation. Amounts of rotational shift were set to 10° (Example 4-2), 15° (Example 4-3), 20° (Example 4-4), 30° (Example 4-5), 60° (Example 4-6), 170° (Example 4-7), and 180° (Example 4-8).

In Example 4-1 to Example 4-8, nitride semiconductor films 21 were successfully formed without generating cracks, etc.

Moreover, bonded substrates 10 before forming a nitride semiconductor film were produced under the same conditions as in each of Example 4-1 to Example 4-8, and strength (breaking load) of each bonded substrate was measured. The strength measurements of each of the bonded substrates 10 were performed in the same way as in Example 1-1 to Example 1-9, and Comparative Examples 1-1 to 1-3. Results of above breaking load (strength) are summarized in Table 4 and shown in FIG. 6.

**[Table 4]**

| | Example 4-1 | Example 4-2 | Example 4-3 | Example 4-4 | Example 4-5 | Example 4-6 | Example 4-7 | Example 4-8 |
|---|---|---|---|---|---|---|---|---|
| Notch Shift (°) | 0 | 10 | 15 | 20 | 30 | 60 | 170 | 180 |
| Strength (N) | 1057 | 1104 | 1501 | 1468 | 1327 | 1324 | 1100 | 1070 |

All of the bonded substrates 10 in Example 4-1 to Example 4-8 had improved strength than those in Comparative Example 3-1, Comparative Example 3-2, and Comparative Example 1-3. Note that Example 4-1 had the same conditions as in Example 3-1, but the data differed due to variations in the experiment.

Among Example 4-1 to Example 4-8, the bonded substrates 10 in Example 4-3 to Example 4-6 had particularly high strength, with even higher strength than Examples 4-1 and 4-2, where a rotational shift between notches of both substrates was less than 15°.

Additionally, the rotational shifts of the notches of both substrates were 170° and 180° in Examples 4-7 and 4-8, respectively, and in these cases, the notches were positioned on the opposite side of a substrate in contrast with respective cases of 10° and 0° (i.e., Examples 4-2 and 4-1). When comparing the strength in Example 4-1 (0°) and the strength in Example 4-8 (180°), the values thereof were close, and when comparing the strength in Example 4-2 (10°) and the strength in Example 4-7 (170°), the values were close. Consequently, when the rotational shifts of the notches of both substrates are 170° and 180°, this is considered equivalent to when the rotational shifts of the notches of both substrates are 10° and 0°, respectively. Accordingly, for example, the rotational shifts of the notches of both substrates are 15° and 165°, this is considered equivalent. Based on the above, this is considered preferable to set the rotational shift of the notches of both substrates between 15° and 165°.

### (Example 5)

A bonded substrate 10, produced under the conditions as in Example 2-5, was adjusted to a thickness of 775 µm by grinding, polishing, and etching after bonding. A strength (breaking load) of this bonded substrate 10 was measured in the same way as in Example 1-1 to Example 1-9, and Comparative Example 1-1 to 1-3. As a result, the breaking load (strength) in Example 5 was 912 N. The breaking load (strength) in Comparative Example 1-3 (that is, an example in which a total thickness of 775 µm was the same as Example 5 but a substrate is composed of a single substrate) was 305 N as shown in Table 1; therefore, the breaking load in Example 5 was improved than that in Comparative Example 1-3.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A substrate for an electronic device, comprising a nitride semiconductor film formed on a bonded substrate comprising a silicon single crystal, wherein
the bonded substrate is a substrate comprising a first silicon single-crystal substrate having a crystal plane orientation of {111} and a second silicon single-crystal substrate having a crystal plane orientation of {111}, being bonded via an oxide film, and
the oxide film has a thickness of 2 nm or more and 470 nm or less.

2. A substrate for an electronic device, comprising a nitride semiconductor film formed on a bonded substrate comprising a silicon single crystal, wherein
the bonded substrate is a substrate comprising a first silicon single-crystal substrate having a crystal plane orientation of {111} and a second silicon single-crystal substrate, being bonded via an oxide film, and
the oxide film has a thickness of 2 nm or more and 470 nm or less.

3. The substrate for an electronic device according to claim 2, wherein
the second silicon single-crystal substrate has a crystal plane orientation of {100}.

4. The substrate for an electronic device according to claim 1 or 2, wherein
the oxide film has a thickness of 2 nm or more and 190 nm or less.

5. The substrate for an electronic device according to claim 1 or 2, wherein
the bonded substrate is a substrate being bonded where a notch of the first silicon single-crystal substrate and a notch of the second silicon single-crystal substrate are rotationally shifted between 15° and 165°.

6. The substrate for an electronic device according to claim 1 or 2, wherein
the bonded substrate has a diameter of 300 mm or more.

7. A method for producing a substrate for an electronic device by forming a nitride semiconductor film on a bonded substrate comprising a silicon single crystal, the method comprising the steps of:
providing a first silicon single-crystal substrate having a crystal plane orientation of {111}, and a second silicon single-crystal substrate having a crystal plane orientation of {111};
forming an oxide film on a surface of at least one of the first silicon single-crystal substrate and the second silicon single-crystal substrate;
producing the bonded substrate by laminating the first silicon single-crystal substrate and the second silicon single-crystal substrate via the oxide film and then heat treating to bond the first silicon single-crystal substrate and the second silicon single-crystal substrate; and
epitaxially growing the nitride semiconductor film on the surface of the first silicon single-crystal substrate of the bonded substrate, wherein
the oxide film to be formed in the step of forming the oxide film is formed to have a thickness in which a thickness of an oxide film that is sandwiched between the first silicon single-crystal substrate and the second silicon single-crystal substrate is 2 nm or more and 470 nm or less.

8. A method for producing a substrate for an electronic device by forming a nitride semiconductor film on a bonded substrate comprising a silicon single crystal, the method comprising the steps of:
providing a first silicon single-crystal substrate having a crystal plane orientation of {111}, and a second silicon single-crystal substrate;
forming an oxide film on a surface of at least one of the first silicon single-crystal substrate and the second silicon single-crystal substrate;
producing the bonded substrate by laminating the first silicon single-crystal substrate and the second silicon single-crystal substrate via the oxide film and then heat treating to bond the first silicon single-crystal substrate and the second silicon single-crystal substrate; and
epitaxially growing the nitride semiconductor film on the surface of the first silicon single-crystal substrate of the bonded substrate, wherein
the oxide film to be formed in the step of forming the oxide film is formed to have a thickness in which a thickness of an oxide film that is sandwiched between the first silicon single-crystal substrate and the second silicon single-crystal substrate is 2 nm or more and 470 nm or less.

9. The method for producing a substrate for an electronic device according to claim 8, wherein
the second silicon single-crystal substrate has a crystal plane orientation of {100}.

10. The method for producing a substrate for an electronic device according to claim 7 or 8, wherein
the oxide film to be formed in the step of forming the oxide film is formed to have a thickness in which a thickness of an oxide film that is sandwiched between the first silicon single-crystal substrate and the second silicon single-crystal substrate is 2 nm or more and 190 nm or less.

11. The method for producing a substrate for an electronic device according to claim 7 or 8, wherein
the first silicon single-crystal substrate and the second silicon single-crystal substrate are bonded where a notch of the first silicon single-crystal substrate and a notch of the second silicon single-crystal substrate are rotationally shifted between 15° and 165°.

12. The method for producing a substrate for an electronic device according to claim 7 or 8, wherein
the first silicon single-crystal substrate and the second silicon single-crystal substrate to be provided have diameters of 300 mm or more.
